Europäisches Patentamt

European Patent Office

Office européen des brevets

(11) Numéro de publication: **0 296 925**
A1

## (12) DEMANDE DE BREVET EUROPEEN

(21) Numéro de dépôt: **88401423.4**

(22) Date de dépôt: **10.06.88**

(51) Int. Cl.⁴: **H 01 L 29/72**
H 01 L 29/267, H 01 L 21/285,
H 01 L 21/60, H 01 L 21/20

(30) Priorité: **12.06.87 FR 8708187**

(43) Date de publication de la demande:
**28.12.88 Bulletin 88/52**

(84) Etats contractants désignés: **DE GB IT NL**

(71) Demandeur: **THOMSON HYBRIDES ET MICROONDES
173, bld Haussmann
F-75008 Paris (FR)**

(72) Inventeur: **Perea, Ernesto
Thomson- CSF SCPI-19, avenue de Messine
F-75008 Paris (FR)**

(74) Mandataire: **Taboureau, James et al
THOMSON-CSF SCPI 19, avenue de Messine
F-75008 Paris (FR)**

(54) Transistor bipolaire à fréquence de coupure élevée.

(57) L'invention concerne un transistor bipolaire, discret ou intégré, réalisé sur un substrat silicium.

Afin de rendre ce transistor très rapide, l'invention prévoit que, tandis que le substrat (1), le collecteur (2, 3) et la base (15, 17) sont en silicium, l'émetteur (18) est en un matériau III-V, tel que Ga As, ayant une plus grande largeur de bande interdite que le silicium. Dans l'hétérojonction émetteur-base ainsi formée, la plus grande largeur de bande interdite du matériau III-V favorise l'efficacité d'injection des électrons dans la base.

Application aux transistors discrets et aux circuits intégrés, en électronique rapide et en hyperfréquence.

FIG.10

EP 0 296 925 A1

## Description

## TRANSISTOR BIPOLAIRE A FREQUENCE DE COUPURE ELEVEE

La présente invention concerne un transistor bipolaire rapide, réalisé dans une plaquette de silicium. Il est caractérisé par l'existence d'une hétérojonction entre son émetteur et sa base, l'émetteur étant fait en un matériau rapide de la famille III-V, tel que Ga As par exemple.

Les dispositifs semiconducteurs tels que les transistors et les circuits intégrés sont essentiellement regroupés en deux types : ceux qui sont réalisés en silicium, et ceux qui sont réalisés en matériaux autres que le silicium, dont les plus courants sont ceux de la famille III-V tels que Ga As ou Al Ga As. L'industrie des semiconducteurs au silicium est la plus avancée, et ses produits sont fiables et économiques. Le silicium a de bonnes qualités thermiques et mécaniques, mais la vitesse de fonctionnement est plus limitée que celle des semiconducteurs sur Ga As qui, jusqu'à présent, sont réservés aux hyperfréquences.

Les limites, en vitesse de fonctionnement, actuellement connues sont de 30 ps, en laboratoire, et 75 ps sur un produit industriel, par porte et pour une consommation de 1 mW par porte.

Ces limitations sont d'ordre physique, et sont imposées par la nature des matériaux constituant les jonctions, en particulier la jonction émetteur-base. Dans les transistors bipolaires Si, cette jonction est une homojonction entre une couche de Si dopée de type n et une couche de Si dopée de type p. L'efficacité d'injection des porteurs de charge, à travers cette jonction est limitée parce qu'il n'y a pas de différence notable de largeur de bande interdite entre le n Si et le p Si.

Selon l'invention, un transistor bipolaire au silicium, considéré en élément discret ou en circuit intégré, est doté d'une plus grande vitesse de fonctionnement, ou, ce qui revient au même, d'une fréquence de coupure élevée, si sa jonction émetteur-base est une hétérojonction, entre un premier matériau tel que Si pour la base, par exemple, et un second matériau ayant une plus grande largeur de bande interdite, pour l'émetteur.

Ce second matériau est préférentiellement choisi parmi ceux de la famille III-V que l'on maîtrise bien, tel que Ga As ou Al Ga As par exemple.

De façon plus précise, l'invention concerne un transistor bipolaire à fréquence de coupure élevée, comportant, supportées par un substrat en silicium, une couche de collecteur et une couche de base qui sont également en silicium, ce transistor étant caractérisé en ce que, en vue d'améliorer l'injection des porteurs de charges électriques à travers la jonction émetteur-base, l'émetteur est réalisé par une couche d'un matériau de la famille III-V formant une hétérojonction émetteur-base avec la couche de base, ce matériau ayant un paramètre de maille cristalline compatible avec le paramètre de maille (5,43 Angstrom) du silicium, et une largeur de bande interdite plus grande que la largeur de bande interdite (1,12 eV à 300°K) du silicium.

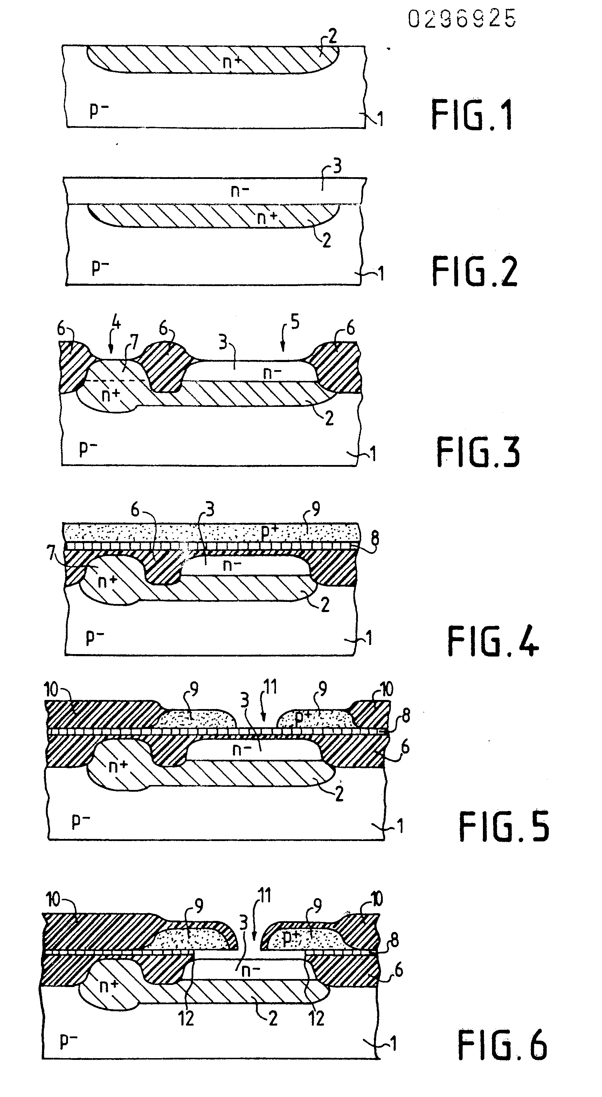

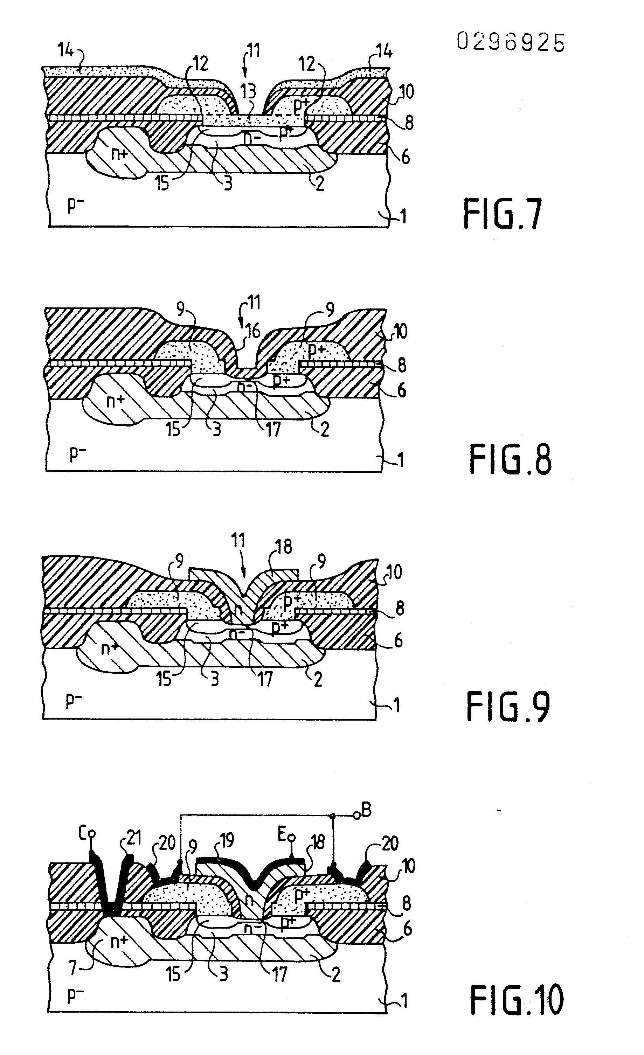

L'invention sera mieux comprise par l'exposé plus détaillé qui suit du fonctionnement d'un transistor, et par la description du procédé de fabrication d'un transistor bipolaire à hétérojonction, cette description s'appuyant sur les figures 1 à 10, jointes en annexe, qui représentent les étapes de fabrication, un transistor selon l'invention étant conforme à la figure 10.

Dans les dispositifs semiconducteurs comportant une jonction, tels que les transistors bipolaires, la vitesse de fonctionnement est liée à la vitesse à laquelle cette jonction se bloque ou devient conductrice, qui est elle-même liée à l'efficacité d'injection de porteurs de charges électriques, à travers cette jonction. On sait que, pour avoir un transistor rapide, il vaut mieux utiliser les électrons, plus mobiles, comme porteurs de charges, plutôt que les trous, comme porteurs majoritaires.

L'efficacité d'injection $\gamma$ des porteurs de charges de l'émetteur dans la base - donc à travers une jonction - est donnée par une expression de la forme :

$$\gamma = 1 - \frac{N_B \, W_B \, D_E}{N_E \, W_E \, D_B} \cdot e^{-\frac{\Delta E_G \, (E, B)}{kT}}$$

dans laquelle :
- $N_B$ et $N_E$ sont les concentrations en impuretés dans la base et dans l'émetteur,
- $W_B$ et $W_E$ sont les épaisseurs des couches de base et d'émetteur,
- $D_B$ et $D_E$ sont les constantes de diffusion des porteurs dans la base et l'émetteur,
- $\Delta E_G \, (E, B) = E_{G \, (E)} - E_{G \, (B)}$ est la différence des largeurs de bandes interdites $E_{G \, (E)}$ dans l'émetteur et $E_{G \, (B)}$ dans la base.

Pour un transistor entièrement en silicium, $E_{G \, (E)} = E_{G \, (B)}$ donc $E_G = 0$, parce que c'est une homojonction, dans le même matériau. L'efficacité d'injection $\gamma$ est maximale, c'est-à-dire proche de 1, si le terme

$$\frac{N_B \; W_B \; D_E}{N_E \; W_E \; D_B} \;\; \text{tend vers } 0.$$

On n'est pas maitre de $D_E$ et $D_B$, qui sont des constantes physiques, mais on peut faire en sorte que :
$W_E \gg W_B$ et $N_E \gg N_B$

Une faible épaisseur de base $W_B$ est favorable à une grande vitesse, mais est limitée par la tenue en tension du transistor (claquage de jonction).

Un faible niveau de dopage de base $N_B$ rend la couche de résistance très élevée, ce qui s'oppose à la vitesse.

La solution dans les transistors au silicium selon l'art connu consiste en un compromis de ces paramètres, et en particulier en une technologie d'autoalignement qui permet des longueurs d'accès à la base très courtes, pour diminuer les résistances d'accès parasites.

Selon l'invention, la solution proposée pour que l'efficacité d'injection
se rapproche de l'unité est de remplacer la couche d'émetteur par une couche d'un matériau formant une hétérojonction avec la couche de base en silicium, à condition de choisir un matériau ayant une largeur de bande interdite différente et plus grande que celle du silicium.

Un transistor a un fonctionnement rapide si:
- la jonction émetteur-base a de bonnes propriétés d'efficacité d'injection des électrons provenant de l'émetteur dans la couche de base,
- la jonction base-collecteur a une capacité la plus faible possible, pour ne pas stocker les électrons.

L'injections d'électrons dans la couche de base se heurte à la présence de trous - puisqu'il s'agit d'un transistor bipolaire - dont une partie se recombine avec les électrons issus de l'émetteur. En réalisant une couche d'émetteur en un matériau qui a une plus grande largeur de bande interdite que celle du silicium de la couche de base, on confère aux électrons une énergie potentielle qui leur permet de résider moins longtemps dans la couche de base, avec en conséquence moins de recombinaisons et donc une meilleure efficacité d'injection.

Cet effet, créé par une hétérojonction sur la jonction émetteur-base, est préférentiellement complété par une homojonction base-collecteur, avec une couche de base fine et dopée pour abaisser la résistance, et une couche dans le collecteur peu dopée pour abaisser la capacité de jonction.

Dans ce cas, $E_{G\,(E)} \neq E_{G\,(B)}$ et $\Delta E_G > 0$ : il est possible d'avoir une base plus dopée que l'émetteur $N_B > N_E$ pour qu'elle soit moins résistante, donc plus rapide et d'obtenir en même temps $\gamma \simeq 1$ à cause du facteur

$$e^{-\frac{\Delta E_G}{kT}}$$

L'invention propose donc un transistor, discret ou en circuit intégré, dont le substrat et différentes couches, dont celles de base et de collecteur notamment, sont en silicium, et dont la couche d'émetteur est en un matériau formant une hétérojonction, et dont la largeur de bande interdite est plus grande que celle du silicium.

Le silicium a une constante de réseau cristallin égale à 5,43 Angstrom et une largeur de bande interdite de 1,12 eV à 300°K. On sait actuellement faire croitre sur le silicium une couche de Ga As, de constante de réseau égale à 5,65 Angstrom, soit 5% d'écart, et de largeur de bande interdite de 1,42 eV, soit 0,3 eV d'écart. Cette croissance est obtenue par épitaxie par jets moléculaires, qui donne une hétérojonction bien définie, de type n pour l'émetteur en Ga As et de type p+ pour la base en silicium. L'impureté introduite dans le Ga As d'émetteur est le silicium, et l'impureté introduite dans le Si de la base est le bore.

L'arséniure de gallium est le matériau rapide, de la famille III-V, le plus couramment utilisé à ce jour, mais d'autres matériaux peuvent être utilisés pour faire la couche d'émetteur. En particulier, les alliages ternaires entre Ga As et Al As, de la forme $Al_{1-x} Ga_x$ As a un paramètre de maille 5,66 Angstrom très proche de celui de Ga As 5,65 Angstrom, et une largeur de bande interdite proche de 2,3 eV plus élevée que celle de Ga As, ce qui favorise l'efficacité d'injection de porteurs dans la jonction. De même, les alliages ternaires entre Ga As et Ga P ou quaternaires entre Ga As et Al P : Ga P et Al P ont un paramètre de maille de 5,65 angstrom qui favorise la croissance épitaxiale sur Si dont le paramètre de maille est 5,43 angstrom. Simultanément, ces deux composés ont une largeur de bande interdite élevée : 2,26 et 2,8 eV respectivement.

Les figures 1 à 10 donnent un exemple de réalisation d'un transistor silicium latéral à hétérojonction selon l'invention. Bien entendu, ce transistor peut être discret, c'est-à-dire isolé, ou en circuit intégré : tout ou partie des transistors d'un circuit intégré en silicium ont un émetteur en matériau formant hétérojonction avec la base. La structure décrite ne limite en rien la portée de l'invention, selon laquelle on peut réaliser des transistors latéraux ou verticaux, munis de différents caissons, et ayant une autre configuration ou un nombre différent de couches semiconductrices ou isolantes.

Le produit de départ est un substrat 1 de silicium dopé de type p⁻. Selon la figure 1, il est masqué par les moyens connus de l'homme de l'art, et une diffusion d'arsénic permet d'y créer une couche superficielle 2 de type n⁺, selon le contour de ce qui sera le collecteur du transistor.

Une fine couche 3 de silicium dopé de type n⁻, en figure 2, est déposée par épitaxie sur la totalité de la surface de la plaquette. C'est dans cette couche que sera pris le contact de collecteur avec la base du transistor.

L'étape suivante, en figure 3, consiste à masquer deux régions 4 et 5 : la région 4 correspond au futur plot de collecteur et la région 5 correspond à la future base du transistor. Une oxydation localisée transforme les parties de la couche 3 qui ne sont pas protégées par masquage en une couche de silice 6. Puis le masque sur la région 4 est dissous et une implantation d'ions d'arsénic transforme en n⁺ la partie 7 de la couche n° 3 qui se trouve dans cette région 4 : le plot formé par la couche n⁺ 7 et la couche n⁺ 2 formera l'accès au collecteur du transistor.

Après oxydation la surface de la plaquette n'est plus plane. En figure 4, les ilôts 6 de silice sont usinés pour les rendre plans, puis une légère oxydation de surface permet le dépôt d'une couche 8 de nitrure puis d'une couche 9 de silicium polycristallin, de type p⁺, dopé par du bore. Cette couche 9 de silicium formera l'accès à la base du transistor.

En figure 5, une région de la couche 9, correspondant à la couche 3 est protégée par masquage, et le silicium polycristallin non masqué est transformé par oxydation localisée en silice 10, puis une ouverture est pratiquée dans la région 11 à travers la couche 9, pour un futur émetteur.

En figure 6, la couche 9 de silicium polycristallin est oxydée en surface, puis à partir du fond de l'ouverture 11, la couche 8 de nitrure de silicium est attaquée latéralement, ainsi que la fine couche 6 de silice qui lui est sous-jacente. L'attaque latérale est arrêtée lorsqu'est atteint un périmètre 12 qui correspond sensiblement au périmètre de la couche 3. Cette attaque latérale a donc creusé une cavité sous la couche 9 de silicium polycristallin.

Cette cavité est remplie, en figure 7, par un dépôt de silicium polycristallin 13,dopé de type p⁺ par des ions de bore. Comme ce dépôt n'est pas directif, le silicium diffuse latéralement dans la cavité dont la trace est marquée par un pointillé.Il se dépose également en 14 à la surface de la plaquette. Au cours de cette opération, une couche superficielle 15 de la couche 3 devient de type p⁺, par diffusion des impuretés du silicium polycristallin 13 : ce sera la couche de base.

L'opération suivante, en figure 8, permet à la fois d'obtenir un émetteur plus fin et une couche de base plus fine, ce qui favorise la vitesse. Ce double résultat est obtenu par une oxydation généralisée de la surface de la plaquette. Au cours de cette oxydation :

- la couche 14 de silicium polycristallin se transforme en silice,

- les bords 16 de l'ouverture 11 se gonflent, ce qui diminue la largeur d'ouverture et permet d'obtenir une résolution supérieure à la résolution maximale des moyens optiques de masquage utilisés - si ce sont des moyens optiques -,

- la partie du silicium de la couche 13, qui se trouve exposée dans le fond de l'ouverture 11, est oxydée en silice, ainsi qu'une partie correspondante de la couche 15 de silicium p⁺ : il en résulte en 17 un amincissement de la couche de base 15.

Au moyen d'un plasma directionnel, en figure 9, le fond de l'ouverture 11 est dégagé de la couche de silice formée à l'étape précédente : la partie amincie 17 de la couche de base 15 est ainsi mise à nu. L'hétérojonction, entre le silicium et un matériau ayant une plus grande largeur de bande interdite, est formée dans le fond de l'ouverture, sur la couche 17. Une couche de Ga As par exemple -ou d'un autre matériau de la famille III-V - dopé de type n par des ions de silicium, y est déposée par épitaxie par jet moleculaire (MBE) ou par déposition d'organométalliques en phase vapeur (MO -CVD). Etant donné la faible surface de l'hétérojonction. sur la couche 17, il n'y a pas de problèmes de disparité des paramètres de maille entre le silicium et l'arséniure de gallium.

La couche de Ga As formée est gravée pour être limitée à un périmètre d'émetteur 18, qui corresponde sensiblement au périmètre de la couche de base 15.

La couche de Ga As est recuite par un recuit flash pour favoriser sa recristallisation et éviter les diffusions d'impuretés entre couches.

La dernière opération, en figure 10, consiste à percer des ouvertures dans la couche de silice 10:

- sur les bords de la couche de silicium 9, pour atteindre celle-ci et prendre contact avec la couche de base 15-17,

- à l'aplomb du plot formé par les couches 7 et 2, pour atteindre la couche 7 et prendre contact avec les couches de collecteur 2 et 3.

Des métallisations 19 sur le Ga As de l'émetteur, 20 sur le silicium p⁺ de la base et 21 sur le silicium n⁺ du collecteur constituent les accès électriques au transistor, et recevront, selon le cas:

- soit des fils d'or s'il s'agit d'un transistor discret,

- soit une interconnexion s'il s'agit d'un circuit intégré.

Le transistor selon l'invention peut avoir une autre architecture, et être dopé différemment, sans sortir du cadre de l'invention. Par exemple, le substrat de départ peut être dopé de type n⁺ au lieu d'être de type p⁻. Dans ce cas, après amincissement, une métallisation à contact ohmique déposée sur la face arrière du

4

substrat correspond au collecteur d'un transistor vertical.

Les modifications à apporter au procédé de fabrication sont alors évidentes pour l'homme de l'art : il est inutile de diffuser la couche n+ 2 et le plot 7, et de percer la couche 10 pour déposer la métallisation 21.

Il est utilisé pour les circuits rapides, qui ne justifient pas encore l'emploi de transistors entièrement en matériaux III-V. En particulier, il permet d'améliorer les performances des circuits intégrés sur silicium.

## Revendications

1. Transistor bipolaire à fréquence de coupure élevée, comportant, supportées par un substrat (1) en silicium, une couche de collecteur (2 + 3 + 7) et une couche de base (15 + 17) qui sont également en silicium, ce transistor étant caractérisé en ce que, en vue d'améliorer l'injection des porteurs de charges électriques à travers la jonction émetteur-base, l'émetteur est réalisé par une couche (18) d'un matériau de la famille III-V formant une hétérojonction émetteur-base avec la couche (17) de base, ce matériau ayant un paramètre de maille cristalle compatible avec le paramètre de maille (5.43 angstrom) du silicium, et une largeur de bande interdite plus grande que la largeur de bande interdite (1,12 eV à 300°K) du silicium.

2. Transistor selon la revendication 1, caractérisé en ce qu'il est de type latéral npn:
   - le substrat est en Si p⁻ (1)
   - le collecteur est en Si n+ (2,7)
   - la base est en Si p+ (15, 17)
   - l'émetteur est en matériau III-V dopé n+ (18).

3. Transistor selon la revendication 1, caractérisé en ce qu'il est de type vertical npn:
   - le substrat et collecteur est en Si n (1)
   - la base est en Si p+ (15, 17)
   - l'émetteur est en mayériau III-V dopé n (18)

4. Transistor selon la revendication 1, caractérisé en ce que la couche d'émetteur (18) est réalisée en l'un parmi les matériaux suivants:
   - Ga As,
   Al $_{1-x}$ Ga$_x$ As,
   alliages ternaires entre Ga As et Ga P,
   alliages quaternaires entre Ga As et Al P.

5. Transistor selon la revendication 1, caractérisé en ce qu'il a une structure verticale, la couche d'émetteur (18) n'étant en contact avec la couche de base (17) que par une faible surface de jonction, en vue de favoriser la croissance du matériau III-V, sur le silicium, et la vitesse de fonctionnement du transistor.

6. Transistor selon la revendication 1, caractérisé en ce que collecteur comprend, au contact avec la couche de base (15, 17) une couche intermédiaire (3), peu dopée (n⁻) afin de diminuer la capacité de la jonction base-collecteur.

0296925

FIG.1

FIG.2

FIG.3

FIG.4

FIG.5

FIG.6

0296925

FIG.7

FIG.8

FIG.9

FIG.10

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | PATENT ABSTRACTS OF JAPAN, vol. 10, no. 11 (E-374)[2068], 17 janvier 1986, page 129 E 374; & JP-A-60 175 450 (TOSHIBA K.K.) 09-09-1985 <br> * Figure 1 * | 1,3,5,6 | H 01 L 29/72 <br> H 01 L 29/267 <br> H 01 L 21/285 <br> H 01 L 21/60 <br> H 01 L 21/20 |
| Y | IDEM | 2 | |
| A | IDEM <br> --- | 4 | |
| Y | JAPANESE JOURNAL OF APPLIED PHYSICS SUPPLEMENTS 16th, 1984 INTERNATIONAL CONFERENCE ON SOLID STATE DEVICES AND MATERIALS, Kobe, 30 août - 1 septembre 1984, pages 209-212, Tokyo, JP; S. KONAKA et al.: "A 30 ps Si bipolar IC using super self-aligned process technology" <br> * Figures 1,3 * | 2 | |
| A | IDEM <br> --- | 5,6 | **DOMAINES TECHNIQUES RECHERCHES (Int. Cl.4)** |
| X | JOURNAL OF VACUUM SCIENCE AND TECHNOLOGY, vol. 21, no. 2, juillet/août 1982, pages 534-539, American Institute of Physics, New York, US; S.L. WRIGHT et al.: "Polar-on-nonpolar epitaxy: Sublattice ordering in the nucleation and growth of GaP on Si(211) surfaces" <br> * Paragraphe II-E: "Electrical data" * | 1 | H 01 L |
| A | IDEM <br> ---                    -/- | 4 | |

Le présent rapport a été établi pour toutes les revendications

| Lieu de la recherche | Date d'achèvement de la recherche | Examinateur |
|---|---|---|
| LA HAYE | 19-09-1988 | MORVAN D.L.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

Office européen
des brevets

**RAPPORT DE RECHERCHE EUROPEENNE**

Numero de la demande

EP  88 40 1423

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | JAPANESE JOURNAL OF APPLIED PHYSICS, vol. 20, supplement 20-1, 1981, pages 9-13, Tokyo, JP; H. KROEMER: "(Invited) Heterostructures for everything: Device principle of the 1980's?" * Page 10, colonne 2, 3 dernières lignes; page 11, colonne 1, 11 premières lignes; figure 1 * | 1 | |
| A | IDEM --- | 4 | |
| A | JOURNAL OF APPLIED PHYSICS, vol. 58, no. 6, septembre 1985, pages 2195-2203, American Institute of Physics, Woodbury, New York, US; P.N. UPPAL et al.: "Molecular beam epitaxial growth of GaAs on Si(211)" * Résumé * ----- | 4 | |

DOMAINES TECHNIQUES
RECHERCHES (Int. Cl.4)

Le présent rapport a été établi pour toutes les revendications

| Lieu de la recherche | Date d'achèvement de la recherche | Examinateur |
|---|---|---|
| LA HAYE | 19-09-1988 | MORVAN D.L.D. |

EPO FORM 1503 03.82 (P0402)